# EUROPEAN PATENT SPECIFICATION

(11) **EP 2 804 674 B1**
(45) Date of publication and mention of the grant of the patent: **11.07.2018**
(21) Application number: 12865718.6
(22) Date of filing: 16.01.2012
(51) Int. Cl.: A62B 9/00, A62B 7/10, A62B 18/00, A62B 18/08, G06F 1/26, G06F 1/32, G01R 31/36, H02J 7/00

(54) **ACCURATE DETERMINATION OF REMAINING TIME TO BATTERY EMPTY IN A POWERED AIR PURIFYING RESPIRATOR**
GENAUE BESTIMMUNG DER RESTZEIT EINER BATTERIE EINES ANGETRIEBENEN LUFTREINIGUNGSATEMGERÄTS
DÉTERMINATION PRÉCISE DU TEMPS RESTANT JUSQU'À CE QUE LA BATTERIE SOIT VIDE DANS UN RESPIRATEUR DE PURIFICATION D'AIR MOTORISÉ

(43) Date of publication of application: 26.11.2014
(73) Proprietor: Honeywell International Inc., Morris Plains, NJ 07950 (US)
(72) Inventor: PALACHARLA, Praveen Kumar, Hyderabad Andhra Pradesh 500050 (IN); PATIL, Swapnil Gopal, Thane Maharashtra 401204 (IN)
(74) Representative: Houghton, Mark Phillip
(86) International application number: PCT/US2012/021413
(87) International publication number: WO 2013/109242

(56) References cited:
- EP-A1- 2 368 745
- WO-A1-2008/055505
- US-A1- 2004 101 412
- US-A1- 2008 312 852
- US-A1- 2009 266 361
- US-A1- 2009 314 295
- US-A1- 2010 315 249
- "SBS 1.1-COMPLIANT GAS GAUGE ENABLED WITH IMPEDANCE TRACK(TM) TECHNOLOGY FOR USE WITH THE bq29312A", , 31 January 2007 (2007-01-31), XP055236818, http://www.ti.com/product/BQ20Z80-V102 Retrieved from the Internet: URL:http://www.ti.com/lit/ds/symlink/bq20z 80-v102.pdf [retrieved on 2015-12-16]
- "bq20z80-V110 + bq29312A Chipset Technical Reference Manual", , 5 April 2007 (2007-04-05), XP055236829, http://www.ti.com/product/BQ20Z80A-V110/te chnicaldocuments Retrieved from the Internet: URL:http://www.ti.com/lit/er/sluu276/sluu2 76.pdf [retrieved on 2015-12-16]

## Description

### BACKGROUND

Powered air purifying respirators (PAPRs) utilize a mechanism, such as a blower or fan or other mechanism, to draw ambient air through air purifying elements to remove contaminants from the air. PAPRs are designed to be human portable for use in atmospheres with solid and liquid contaminants, gases, and/or vapors to provide a useable and safe supply of breathable air where the concentrations of contaminants is not immediately dangerous to life or health and the atmosphere contains adequate oxygen to support life. PAPRs carry a self-contained power source such as a battery to energize a motor to drive the flower or fan. The self-contained power source desirably is sized small enough so the PAPR is readily human portable and large enough that the PAPR can be used without recharging the power source for a portion of a work shift effective to promote efficient worker operation.

### SUMMARY

The present invention is defined by the appended claims.

In an embodiment, a powered air purifying respirator that alerts when remaining battery time is below a predefined threshold is disclosed. The powered air purifying respirator comprises an electric motor mechanically coupled to a blower, a battery coupled to the electric motor, an alarm device, and an electronic controller. The electronic controller determines a second battery time remaining value and actuates the alarm device when the second battery time remaining value is less than a predefined threshold, wherein the controller determines the second battery time remaining value based on indexing into a look-up table of values with a first battery time remaining value and a battery voltage.

In an embodiment, a method of monitoring a powered air purifying respirator battery time remaining is disclosed. The method comprises sensing a battery voltage of a battery of the powered air purifying respirator, sensing a battery current of the battery, sensing a battery temperature of the battery, maintaining a value of battery age of the battery, determining a first value of battery time remaining based on the battery voltage, the battery temperature, the value of battery age, and the battery current. The method further comprises determining a second value of battery time remaining by indexing into a first look-up table using the battery voltage and the first value of battery time remaining and, when the second value of battery time remaining is below a predefined threshold, actuating an alarm.

In an embodiment, a powered air purifying respirator is disclosed. The powered air purifying respirator comprises an electric motor mechanically coupled to a blower, a battery coupled to the electric motor, an alarm device, a battery monitor integrated circuit, and an electronic controller. The battery monitor integrated circuit maintains a value of battery age and determines a first value of battery time remaining based on a sensed battery temperature, a sensed battery voltage, a sensed battery current, and the value of battery age. The electronic controller determines a second value of battery time remaining based on indexing into a first look-up table using the first value of battery time remaining and the sensed battery voltage and actuates the alarm device when the second value of battery time remaining is less than a predefined threshold.

These and other features will be more clearly understood from the following detailed description taken in conjunction with the accompanying drawings and claims.

### BRIEF DESCRIPTION OF THE DRAWINGS

For a more complete understanding of the present disclosure, reference is now made to the following brief description, taken in connection with the accompanying drawings and detailed description, wherein like reference numerals represent like parts.
FIG. 1 is an illustration of a control system according to an embodiment of the disclosure.
FIG. 2 is an illustration of a memory according to an embodiment of the disclosure.
FIG. 3A, FIG. 3B, and FIG. 3C are a flow chart of a method according to an embodiment of the disclosure.
FIG. 4 is an illustration of an exemplary computer system suitable for implementing some aspects of an embodiment of the disclosure.

### DETAILED DESCRIPTION

It should be understood at the outset that although illustrative implementations of one or more embodiments are illustrated below, the disclosed systems and methods may be implemented using any number of techniques, whether currently known or not yet in existence. The disclosure should in no way be limited to the illustrative implementations, drawings, and techniques illustrated below, but may be modified within the scope of the appended claims along with their full scope of equivalents.

Powered air purifying respirators (PAPRs) are well known in the art. An exemplary PAPR is described in US patent application publication US 2011/0146682 A1 entitled "Sensor Apparatus and Method to Regulate Air Flow in a Powered Air Purifying Respirator" by Swapnil Gopal Patil, *et al*, published June 23, 2011, US patent application number 12/645,044 filed December 22, 2009. US2009/0266361 A1 discloses an example of a PAPR, which alerts the user that the battery is about to expire and that the user should leave the hazardous area before the system shuts down. A PAPR may comprise a motor mechanically coupled to an air blower. As the motor turns the air blower, the air blower draws air through one or more filters and delivers breathable air to a user, for example, via a hose to a face mask or a hood worn by the user.

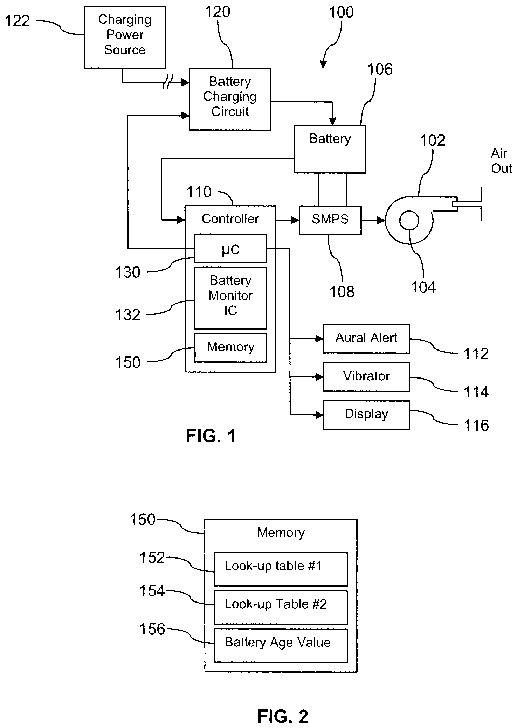

Turning now to FIG. 1, a system 100 is described. In an embodiment, the system 100 is a PAPR and comprises an air blower 102, an electric motor 104, a battery 106, a switched mode power supply (SMPS) 108, a controller 110, an aural alert device 112, a vibrator device 114, and a display device 116. It is understood that some components commonly present in PAPRs are not shown in FIG. 1 to avoid cluttering the illustration. For example, in an embodiment, the air outlet at the right hand side of the illustration may be coupled into an air hose attached to a face mask or to a hood. In an embodiment, the system 100 may be varied in some ways, and some components may be combined. For example, in an embodiment, the system 100 may comprise only one or two of the aural alert device 112, the vibrator device 114, and the display device 116. The aural alert device 112 may be a buzzer device, a speaker device that plays a pre-recorded alert tone, or another device. The display device 116 may be a touch screen display, a liquid crystal display (LCD), an array of light emitting diodes (LEDs), one or more indicator lights or LEDs, or other type of display.

In an embodiment, the system 100 may not employ the switched mode power supply 108 but instead may employ some other form of electrical power modulation component to modulate the electrical power delivered to the electric motor 104 under control of the controller 110. In an embodiment, the system 100 may not employ the switched mode power supply 108, and the controller 110 may comprise the circuitry for electrical power modulation and may connect directly to the electric motor 104 and to the battery 106. In an embodiment, the system 100 further comprises a battery charging circuit 120 that may be coupled to an external charging power source 122. The battery charging circuit 120 may control charging current provided to the battery 106 during a charging mode of operation, for example limiting charging current flow and charging voltage provided to the battery 106. In an embodiment, the battery 106 may be a Lithium-ion battery, but in other embodiments different types of batteries may be employed in the system 100.

In an embodiment, the controller 110 may comprise a micro-controller 130, a battery monitor integrated circuit (IC) 132, and a memory 150. Each of the micro-controller 130, the battery monitor IC 132, and the memory 150 may be separate integrated circuits. Alternatively, two more of the micro-controller 130, the battery monitory IC 132, and the memory 150 may be combined in a single integrated circuit. In an embodiment, the battery monitor IC 132 may be integrated with or packaged with the battery 106, and the battery monitor IC 132 may be coupled to the controller 110 and/or the micro-controller 130. In an embodiment, the battery monitor IC 132 may be selected from the TEXAS INSTRUMENTS bq20zxx family of integrated circuit chips.

The switched mode power supply 108 may deliver a pulsed electrical power output to the electric motor 104 that is characterized by a voltage amplitude and a pulse duration or width. By increasing the output pulse duration of the switched mode power supply 108, the controller 110 indirectly commands the electric motor 104 to turn faster and hence to increase the air flow rate produced by the air blower 102. By decreasing the output pulse duration of the switched mode power supply 108, the controller 110 indirectly commands the electric motor 104 to turn slower and hence to decrease the air flow rate produced by the air blower 102. It is understood that the pulse duration or width of the pulsed electrical power output to the electric motor 104 may also be adapted by the controller 110 based on different amounts of backpressure in the PAPR system and/or different filter characteristics.

A feedback loop (not shown) provides an indication of the air flow rate being delivered to the controller 110, and the controller 110 modulates the switched mode power supply 108 to maintain a standard air flow rate, for example to supply a standard rate of air flow to a user of the powered air purifying respirator. A sensor (not shown) in the feedback loop provides an indication of the air flow. In an embodiment, the sensor comprises a first probe located in an airflow channel of the PAPR that measures a stagnation pressure in the airflow channel and a second probe located to measure a static pressure in the airflow channel. The sensor compares the difference of pressures sensed by the first probe and the second probe to develop an indication of air flow rate. For further details of a differential pressure based air flow rate sensor, see US patent application publication US 2011/0146682 A1 entitled "Sensor Apparatus and Method to Regulate Air Flow in a Powered Air Purifying Respirator" by Swapnil Gopal Patil, *et al.* In another embodiment, however, a different kind of sensor may be used to provide an indication or air flow. The output of the sensor may be filtered to remove noise and to smooth the sensor output before processing by the controller 110.

The electrical load placed on the battery 106 by the switched mode power supply 108 to maintain, under the command of the controller 110, the standard air flow rate may vary due to unit-to-unit discrepancies between different PAPRs, due to different air filters (not shown) employed by the PAPR, and due to using different face masks and/or hoods (not shown) to deliver the purified air flow to the user of the PAPR. The system 100 is designed to provide an alarm when the battery remaining life drops below or is below a predefined threshold.

It has been found that Lithium-ion batteries, given a constant discharge current, have a relatively constant voltage as the battery is discharged, out to a point where the battery voltage drops relatively rapidly as the battery further discharges. As a result of this property of Lithium-ion batteries, it may be difficult to accurately estimate a remaining battery life based on battery terminal voltage and discharge current alone. It is desirable to accurately estimate remaining battery life in order to permit workers to return to a PAPR stock room and replace a first PAPR having a fully discharged battery with a second PAPR having a charged battery before the first PAPR stops working. If the first PAPR stops working before the worker has returned to the PAPR stock room, the worker may be exposed to the hazard of breathing unfiltered work environment air. Additionally, it is desirable to not estimate an impending fully discharged battery condition when this is not the case, because this pessimistic assessment of battery state of charge may result in unnecessary loss of worker time. The accuracy standard for estimating battery remaining time is being raised. For example, the National Institute of Occupational Safety and Health (NIOSH) is planning to activate a new accuracy standard for estimating battery remaining time for PAPRs in 2013.

In an embodiment, the battery monitor IC 132 estimates a first value of battery time remaining based on a battery terminal voltage of the battery 106, a battery current of the battery 106, a battery temperature of the battery 106, and a value of battery age of the battery 106. The battery terminal voltage may be provided to the controller 110 and/or the battery monitor IC 132 from a voltage sensor coupled to the battery 106. The battery current may be provided to the controller 110 and/or the battery monitor IC 132 from a current sensor coupled to the battery 106. The controller and/or the battery monitor IC 132 may maintain a value of battery age over the life of the battery 106. The value of battery age may be determined based on a count of charging cycles that the battery 106 has experienced. The value of battery age may further be determined based at least in part on a calendar age - for example a number of weeks, months, years, or some other time interval since initial assembly of the battery. The value of battery age may further be determined based at least in part on a depth of discharge among the charging cycles. The battery monitor IC 132 may estimate the first value of battery time according to a battery internal impedance algorithm and/or a battery impedance track technology. In an embodiment, the battery monitor IC 132 estimates a first value of time to battery charged based on the battery terminal voltage, the battery current, the battery temperature, and the value of battery age using the battery internal impedance algorithm and/or the battery impedance track technology.

In an embodiment, the first value of battery time remaining and/or the first value of time to battery charged may not be accurate enough to satisfy regulatory standards and/or to achieve desirable operational results. To improve estimate accuracy, the present disclosure teaches the micro-controller 130 indexing into a first look-up table using the first value of battery time remaining and the battery voltage to look up a second value of battery time remaining and indexing into a second look-up table using the first value of time to battery charged and the battery voltage to look up a second value of time to battery charged. The values of battery time remaining and the time to battery charged stored in the first and second look-up tables may provide more accurately determined values for the system 100. The values in the first and second look-up tables may be the same for all units of a given model of PAPR. Alternatively, the values in the first and second look-up tables may be determined independently for a single instance of the system 100, for example during initial calibration and test of the system 100 at time of assembly.

As is known to one skilled in the art, for values of the first value of battery time remaining and the battery voltage that fall between predefined entries in the first look-up table, the micro-controller may interpolate between the predefined look-up values in the first look-up table to determine the second value of battery time remaining using any of a variety of interpolation algorithms, for example a linear interpolation, a polynomial interpolation, or some other interpolation. Likewise, for values of the first value of time to battery charged and battery voltage that fall between predefined entries in the second look-up table, the micro-controller may interpolate in a similar manner between the predefined look-up values in the second look-up table to determine the second value of time to battery charged.

Turning now to FIG. 2, a memory 150 is described. The memory 150 may be part of a memory chip that is coupled to the controller 110 or may be part of a memory integrated with a processor chip such as the micro-controller 130 or some other processor. In an embodiment, the memory 150 comprises a first look-up table 152, a second look-up table 154, and a battery age value 156. The look-up tables 152, 154 may be conceptualized as two-dimensional tables having columns and rows, although this conceptualization does not imply any specific implementation. In an embodiment, the look-up tables 152, 154 are implemented as a sequence of memory locations and any abstraction of the look-up tables 152, 154 as a multi-dimensional structure is provided by micro-code, firmware, and/or software executed by the controller 110 and/or the micro-controller 130. The look-up tables 152, 154 may be defined to have any number of columns and any number of rows. One skilled in the art will appreciate that there is a trade-off between increased accuracy and increased complexity associated with the number of columns and the number of rows used to create and use the look-up tables 152, 154. While in an embodiment, it is contemplated that the look-up tables 152, 154 are indexed by two different parameters, in an embodiment, one or both of the look-up tables 152, 154 may be indexed by more than two different parameters. For example, in an embodiment, the first look-up table 152 may be indexed by the first value of battery time remaining, by the battery voltage, and by one or more additional parameters of the battery temperature, the battery age value, and/or other battery parameters.

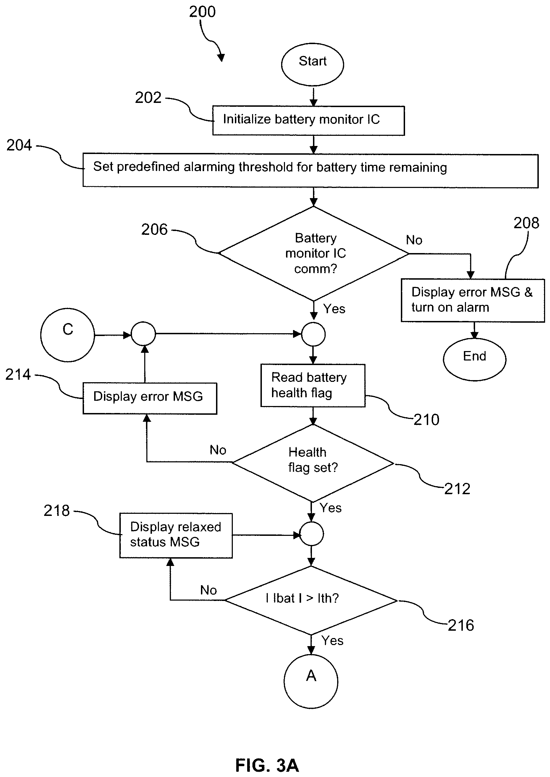

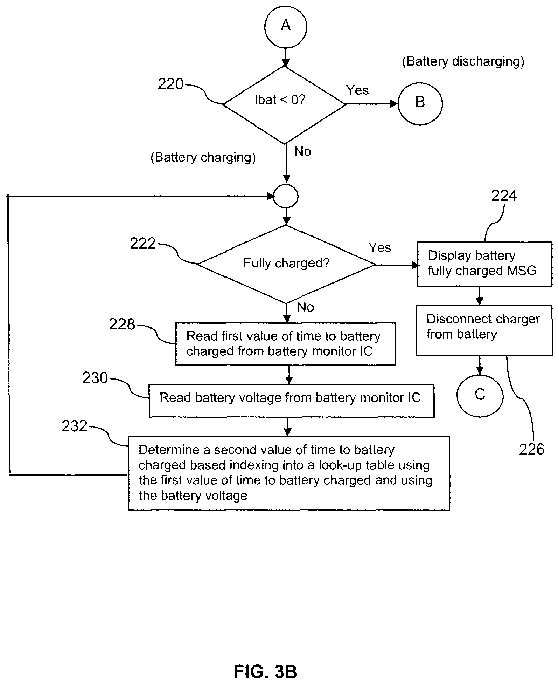

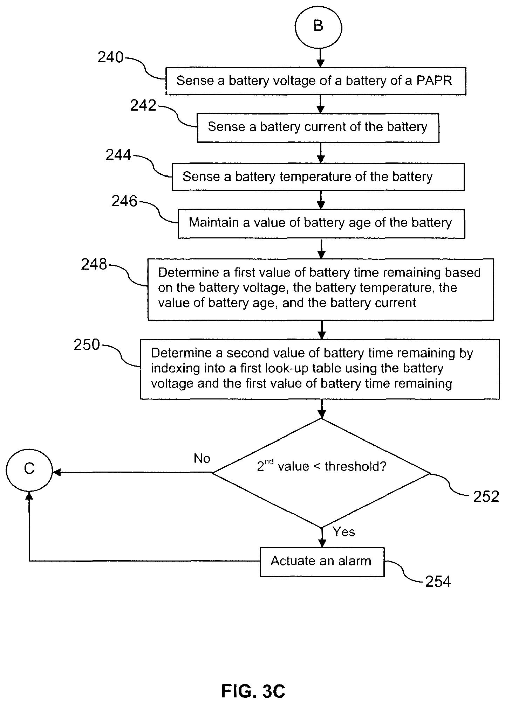

Turning now to FIG. 3A, FIG. 3B, and FIG. 3C, a method 200 is described. It is understood that in some embodiments, the system 100 may perform all or only some of the processing of method 200. For example, in an embodiment, the system 100 may perform the steps associated with determining the second value of battery time remaining according to method 200, but may not determine the second value of time to battery charged according to method 200 but instead may use some other method. For example, the system 100 may determine a single estimated value of time to battery charged based simply on battery voltage, without resorting to any table look-up. In an embodiment, some of the steps of the method 200 may be re-sequenced so that while a first step is illustrated in FIG. 3A, FIG. 3B, or FIG. 3C happening before a second step, in another embodiment, the second step may be performed before the first step. Other deviations from the completely described process of method 200 are also contemplated by the present disclosure.

The method 200 may be considered to begin when the battery 106 is first assembled with the system 100. Alternatively, the method 200 may be considered to begin when the battery 106 is first assembled, for example when the battery monitor IC 132 is part of the battery 106 and/or is physically coupled to the battery 106. At block 202, the battery monitor IC 202 is powered on and/or initialized. At block 204, a predefined alarming threshold for battery time remaining is set. For example, a time in minutes is configured into the system 100. The alarming threshold may be stored in the memory 150, in the micro-controller 130, or in another location. The alarming threshold may be written into the system 100 by a tool during the manufacturing process. In an embodiment, the setting of the predefined alarming threshold for battery time remaining may be integrated with loading firmware into the controller 110 and/or into the micro-controller 130.

At block 206, a determination is made whether the battery monitor IC 132 has established communication with the controller 110 and/or the micro-controller 130. If there are no communications established between the controller 110 and the battery monitor IC 132, an error message is displayed and/or an alarm is turned on. For example, an error message may be displayed on the display device 116 and an alarm may be presented by one or both of the aural alert device 112 and the vibrator device 114. The aural alert provided by the aural alert device 112 may be a buzzer sound or a recorded tone that is cycled through one or more times. If communication is successfully established between the battery monitor IC 132 and the controller 110 and/or the micro-controller 130, the processing proceeds to block 210.

At block 210 a battery health status and/or battery health flag is read. At block 212, if the battery health flag is not set or if the battery health status does not correspond to "operable" or "healthy," the processing proceeds to block w14 where an appropriate error message is displayed. If the battery health flat is set or if the battery is determined to be healthy, the processing proceeds to block 216. At block 216, if the absolute value of the battery current (I_{bat}) is less than a current threshold (Iₜₕ), the processing proceeds to block 218. At block 218, a message is displayed indicating the battery 106 is in a relaxed status - the battery 106 is neither being charged nor supplying substantial current to drive the motor 104. If the absolute value of the battery current exceeds the current threshold, the processing proceeds to block 220 shown in FIG. 3B.

At block 220, if the battery current is less than zero - a condition corresponding to discharging the battery 106 and/or the battery 106 supplying power to the electric motor 104 - the processing proceeds to block 240 shown in FIG. 3C. If the battery current is not less than zero (hence the battery current is greater than zero, otherwise processing at block 216 would have proceeded to block 218) - a condition corresponding to charging the battery 106 - the processing proceeds to block 222. If the battery 106 is determined, for example by the controller 110 or by the micro-controller 130, to be fully charged, processing proceeds to block 224 where a message is displayed indicating that the battery 106 is fully charged and at block 226 the battery charging circuit 120 is disconnected from the battery 106, for example by opening a micro-switch within the battery charging circuit or electronically by changing the bias of a current controlling semiconductor device such as a transistor. The processing then proceeds to block 210.

At block 222, if the battery 106 is not fully charged, the processing proceeds to block 228. At block 228, a first value of time to battery charged is read or received from the battery monitor IC 132. At block 230 the battery voltage is read or received from the battery monitor IC 132. Alternatively, in an embodiment, the sensed battery voltage may be available to the controller 110 or the micro-controller 130 from a battery voltage sensor. At block 232, a second value of time to battery charged is determined based on indexing into a look-up table - for example the second look-up table 154 described above with reference to FIG. 2 - using the first value of time to battery charged and using the battery voltage. Determining the second value of time to battery charged may involve interpolating between predefined data points in the look-up table.

When the battery is determined to be discharging at block 220, processing proceeds to block 240 shown in FIG. 3C. At block 240, a battery voltage of a battery of a PAPR is sensed. At block 242, a battery current of the battery is sensed. At block 244, a battery temperature of the battery is sensed. For example the battery voltage, the battery current, and the battery temperature of the battery 106 of the system 100 is sensed. At block 246, a value of battery age of the battery is maintained, for example as described above. While FIG. 3B shows the method 200 passing at block 232 back to block 222, in an alternative embodiment the method 200 may proceed from block 232 block 210. In an embodiment, the method 200 may perform a further step (not shown) of determining battery health or battery status and may set the battery health flag or battery health status described above with reference to block 206. This step of determining battery health may be performed at a variety of points in the sequence of the method 200, for example after block 232 and before other processing. Additionally, the step of determining battery health may be performed at a plurality of points within the method 200.

At block 248, a first value of battery time remaining is determined based on the battery voltage, the battery temperature, the value of battery age, and the battery current. For example, the battery monitor IC 132 determines the first value of battery time remaining. At block 250, a second value of battery time remaining is determined by indexing into a first look-up table using the battery voltage and the first value of battery time remaining. For example, the micro-controller 130 looks-up the second value of battery time remaining from the first look-up table 152, using the first value of battery time remaining and the battery voltage to index into the first look-up table 152. In an embodiment, the micro-controller 130 may determine the second value of battery time remaining by interpolating between predefined values of battery time remaining stored in the first look-up table 152.

At block 252, if the second value of battery time remaining is less than a predefined threshold, an alarm is actuated at block 254, otherwise the processing proceeds to block 210 shown in FIG. 3A. The alarm actuated at block 254 may be provided by the aural alert device 112, the vibrator device 114, and/or the display device 116. The predefined threshold may be defined by one skilled in the art such that when the alarm is actuated, there is sufficient battery time remaining - residual battery capacity for driving the electronic motor 104 - to allow the user of the system 100 to return to a location where they can replace their PAPR with another PAPR that does not have a depleted battery 106. For example, the predefined threshold may be one minute of time, five minutes of time, ten minutes of time, thirty minutes of time, or some other predefined time threshold. While the method 200 has described the monitoring the battery 106 based on determining a time to battery discharged and/or a time to battery fully charged, it is understood that other units for representing and calculating battery state-of-charge may be used. For example, in an embodiment, the battery state-of-charge may be represented as a fraction of full charge.

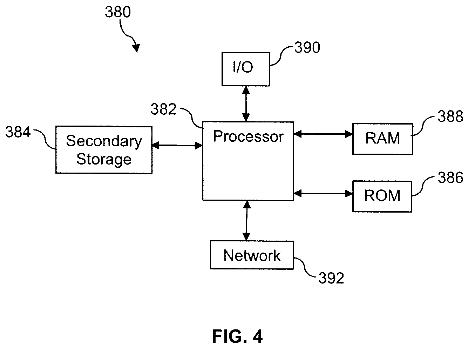

FIG. 4 illustrates a computer system 380 suitable for implementing one or more aspects of the embodiments disclosed herein, for example the controller 110 may share some of the structures of the computer system 380. In an embodiment, the computer system 380 comprises a processor 382 (which may be referred to as a central processor unit or CPU) that is in communication with memory devices including secondary storage 384, read only memory (ROM) 386, random access memory (RAM) 388, input/output (I/O) devices 390, and network connectivity devices 392. The processor 382 may be implemented as one or more CPU chips. In some embodiments, the computer system 380 may not comprise all of the components enumerated above. For example, in an embodiment, the computer system 380 may not have secondary storage 384. Additionally, some of the components listed separately above may be combined in a single component, for example the processor 380, the ROM 386, and the RAM 388 may be integrated in a single component and/or single semiconductor chip.

It is understood that by programming and/or loading executable instructions onto the computer system 380, at least one of the CPU 382, the RAM 388, and the ROM 386 are changed, transforming the computer system 380 in part into a particular machine or apparatus having the novel functionality taught by the present disclosure. It is fundamental to the electrical engineering and software engineering arts that functionality that can be implemented by loading executable software into a computer can be converted to a hardware implementation by well known design rules. Decisions between implementing a concept in software versus hardware typically hinge on considerations of stability of the design and numbers of units to be produced rather than any issues involved in translating from the software domain to the hardware domain. Generally, a design that is still subject to frequent change may be preferred to be implemented in software, because re-spinning a hardware implementation is more expensive than re-spinning a software design. Generally, a design that is stable that will be produced in large volume may be preferred to be implemented in hardware, for example in an application specific integrated circuit (ASIC), because for large production runs the hardware implementation may be less expensive than the software implementation. Often a design may be developed and tested in a software form and later transformed, by well known design rules, to an equivalent hardware implementation in an application specific integrated circuit that hardwires the instructions of the software. In the same manner as a machine controlled by a new ASIC is a particular machine or apparatus, likewise a computer that has been programmed and/or loaded with executable instructions may be viewed as a particular machine or apparatus.

The secondary storage 384 is typically comprised of one or more disk drives or tape drives and is used for non-volatile storage of data and as an over-flow data storage device if RAM 388 is not large enough to hold all working data. Secondary storage 384 may be used to store programs which are loaded into RAM 388 when such programs are selected for execution. The ROM 386 is used to store instructions and perhaps data which are read during program execution. ROM 386 is a non-volatile memory device which typically has a small memory capacity relative to the larger memory capacity of secondary storage 384. The RAM 388 is used to store volatile data and perhaps to store instructions. Access to both ROM 386 and RAM 388 is typically faster than to secondary storage 384. The secondary storage 384, the RAM 388, and/or the ROM 386 may be referred to in some contexts as computer readable storage media and/or non-transitory computer readable media.

I/O devices 390 may include printers, video monitors, liquid crystal displays (LCDs), touch screen displays, keyboards, keypads, switches, dials, mice, track balls, voice recognizers, card readers, paper tape readers, or other well-known input devices.

The network connectivity devices 392 may take the form of modems, modem banks, Ethernet cards, universal serial bus (USB) interface cards, serial interfaces, token ring cards, fiber distributed data interface (FDDI) cards, wireless local area network (WLAN) cards, radio transceiver cards such as code division multiple access (CDMA), global system for mobile communications (GSM), long-term evolution (LTE), worldwide interoperability for microwave access (WiMAX), and/or other air interface protocol radio transceiver cards, and other well-known network devices. These network connectivity devices 392 may enable the processor 382 to communicate with the Internet or one or more intranets. With such a network connection, it is contemplated that the processor 382 might receive information from the network, or might output information to the network in the course of performing the above-described method steps. Such information, which is often represented as a sequence of instructions to be executed using processor 382, may be received from and outputted to the network, for example, in the form of a computer data signal embodied in a carrier wave.

Such information, which may include data or instructions to be executed using processor 382 for example, may be received from and outputted to the network, for example, in the form of a computer data baseband signal or signal embodied in a carrier wave. The baseband signal or signal embedded in the carrier wave, or other types of signals currently used or hereafter developed, may be generated according to several methods well known to one skilled in the art. The baseband signal and/or signal embedded in the carrier wave may be referred to in some contexts as a transitory signal.

The processor 382 executes instructions, codes, computer programs, scripts which it accesses from hard disk, floppy disk, optical disk (these various disk based systems may all be considered secondary storage 384), ROM 386, RAM 388, or the network connectivity devices 392. While only one processor 382 is shown, multiple processors may be present. Thus, while instructions may be discussed as executed by a processor, the instructions may be executed simultaneously, serially, or otherwise executed by one or multiple processors. Instructions, codes, computer programs, scripts, and/or data that may be accessed from the secondary storage 384, for example, hard drives, floppy disks, optical disks, and/or other device, the ROM 386, and/or the RAM 388 may be referred to in some contexts as non-transitory instructions and/or non-transitory information.

In an embodiment, the computer system 380 may comprise two or more computers in communication with each other that collaborate to perform a task. For example, but not by way of limitation, an application may be partitioned in such a way as to permit concurrent and/or parallel processing of the instructions of the application. Alternatively, the data processed by the application may be partitioned in such a way as to permit concurrent and/or parallel processing of different portions of a data set by the two or more computers. In an embodiment, virtualization software may be employed by the computer system 380 to provide the functionality of a number of servers that is not directly bound to the number of computers in the computer system 380. For example, virtualization software may provide twenty virtual servers on four physical computers. In an embodiment, the functionality disclosed above may be provided by executing the application and/or applications in a cloud computing environment. Cloud computing may comprise providing computing services via a network connection using dynamically scalable computing resources. Cloud computing may be supported, at least in part, by virtualization software. A cloud computing environment may be established by an enterprise and/or may be hired on an as-needed basis from a third party provider. Some cloud computing environments may comprise cloud computing resources owned and operated by the enterprise as well as cloud computing resources hired and/or leased from a third party provider.

In an embodiment, some or all of the functionality disclosed above may be provided as a computer program product. The computer program product may comprise one or more computer readable storage medium having computer usable program code embodied therein to implement the functionality disclosed above. The computer program product may comprise data structures, executable instructions, and other computer usable program code. The computer program product may be embodied in removable computer storage media and/or non-removable computer storage media. The removable computer readable storage medium may comprise, without limitation, a paper tape, a magnetic tape, magnetic disk, an optical disk, a solid state memory chip, for example analog magnetic tape, compact disk read only memory (CD-ROM) disks, floppy disks, jump drives, digital cards, multimedia cards, and others. The computer program product may be suitable for loading, by the computer system 380, at least portions of the contents of the computer program product to the secondary storage 384, to the ROM 386, to the RAM 388, and/or to other non-volatile memory and volatile memory of the computer system 380. The processor 382 may process the executable instructions and/or data structures in part by directly accessing the computer program product, for example by reading from a CD-ROM disk inserted into a disk drive peripheral of the computer system 380. Alternatively, the processor 382 may process the executable instructions and/or data structures by remotely accessing the computer program product, for example by downloading the executable instructions and/or data structures from a remote server through the network connectivity devices 392. The computer program product may comprise instructions that promote the loading and/or copying of data, data structures, files, and/or executable instructions to the secondary storage 384, to the ROM 386, to the RAM 388, and/or to other non-volatile memory and volatile memory of the computer system 380.

In some contexts, the secondary storage 384, the ROM 386, and the RAM 388 may be referred to as a non-transitory computer readable medium or a computer readable storage media. A dynamic RAM embodiment of the RAM 388, likewise, may be referred to as a non-transitory computer readable medium in that while the dynamic RAM receives electrical power and is operated in accordance with its design, for example during a period of time during which the computer 380 is turned on and operational, the dynamic RAM stores information that is written to it. Similarly, the processor 382 may comprise an internal RAM, an internal ROM, a cache memory, and/or other internal non-transitory storage blocks, sections, or components that may be referred to in some contexts as non-transitory computer readable media or computer readable storage media.

While several embodiments have been provided in the present disclosure, it should be understood that the disclosed systems and methods may be embodied in many other specific forms without departing from the spirit or scope of the present disclosure. The present examples are to be considered as illustrative and not restrictive, and the intention is not to be limited to the details given herein. For example, the various elements or components may be combined or integrated in another system or certain features may be omitted or not implemented.

Also, techniques, systems, subsystems, and methods described and illustrated in the various embodiments as discrete or separate may be combined or integrated with other systems, modules, techniques, or methods without departing from the scope of the present disclosure. Other items shown or discussed as directly coupled or communicating with each other may be indirectly coupled or communicating through some interface, device, or intermediate component, whether electrically, mechanically, or otherwise. Other examples of changes, substitutions, and alterations are ascertainable by one skilled in the art and could be made without departing from the scope disclosed herein.

## Claims

1. A powered air purifying respirator (PAPR), comprising:
an electric motor (104) mechanically coupled to a blower (102);
a battery (106) coupled to the electric motor (104);
an alarm device (112, 114, or 116); and
an electronic controller (130), wherein the controller (130) determines a second battery time remaining value based on indexing into a look-up table of values using a first battery time remaining value and a battery voltage to look up the second battery time remaining value, wherein the first battery time remaining value is an estimate of the battery remaining time based at least in part on a value of battery age, a sensed battery voltage, a sensed battery current, and a sensed battery temperature, wherein the electronic controller (13) actuates the alarm device (112, 114, or 116) when the second battery time remaining value is less than a predefined threshold, wherein the second battery time remaining value is a more accurately determined time remaining value for the powered air purifying respirator than the first battery time remaining value.

2. The powered air purifying respirator of claim 1, wherein the alarm device (112, 114, or 116) is at least one of a buzzer alarm (112) or a vibration alarm (114).

3. The powered air purifying respirator of claim 1, wherein the battery (106) is a Lithium- ion battery.

4. The powered air purifying respirator of claim 1, further comprising a battery monitor integrated circuit (132) that determines the first battery time remaining value, and wherein the battery monitor integrated circuit (132) transmits the first battery time remaining value and the sensed battery voltage to the electronic controller (130).

5. The powered air purifying respirator of claim 4, wherein the battery monitor integrated circuit (132) further determines a first value of time remaining to battery fully charged based on the battery voltage, the battery temperature, the battery age, and the battery current; and the electronic controller (130) further determines a second value of time remaining to battery fully charged by indexing into a second look-up table using the battery voltage and the first value of time remaining until battery fully charged.

6. The powered air purifying respirator of claim 5, further comprising, when the second value of time remaining to battery fully charged indicates the battery is fully charged, the electronic controller (130) is configured to disconnect a charger (120) from the battery (106).

7. A method of monitoring a powered air purifying respirator (PAPR) battery time remaining, comprising:
sensing a battery voltage of a battery (106) of the powered air purifying respirator;
sensing a battery current of the battery (106);
sensing a battery temperature of the battery (106);
maintaining a value of battery age of the battery (106);
determining a first value of battery time remaining based on the battery voltage, the battery temperature, the value of battery age, and battery current;
determining a second value of battery time remaining by indexing into a first look-up table using the battery voltage and the first value of battery time remaining to look up the second value of the battery time remaining, wherein the second value of the battery time remaining is a more accurately determined value of the battery time remaining for the powered air purifying respirator than the first value of the battery time remaining; and
when the second value of battery time remaining is below a predefined threshold, actuating an alarm (112, 114, or 116).

8. The method of claim 7, further comprising:
determining a first value of time remaining to battery fully charged based on the battery voltage, the battery temperature, the value of battery aging, and the battery current; and
determining a second value of time remaining to battery fully charged by indexing into a second look-up table using the battery voltage and the first value of time remaining until battery fully charged.

9. The method of claim 8, further comprising:
when the second value of time remaining to battery fully charged indicates the battery (106) is fully charged, disconnecting a charger from the battery (106); and presenting a message on a display of the powered air purifying respirator indicating the battery (106) is fully charged when the second value of time remaining to battery fully charged indicates the battery (106) is fully charged.

10. The method of claim 7, when the second value of battery time remaining is below a second predefined threshold, decoupling the battery (106) from an electric motor (104) of the powered air purifying respirator, wherein the second predefined threshold has a lower value than the first predefined threshold value.

11. The method of claim 7, further comprising presenting the second value of battery time remaining on a display of the powered air purifying respirator.

## Patentansprüche

1. Angetriebenes Luftreinigungsatemgerät (PAPR), Folgendes umfassend:
einen Elektromotor (104), der mechanisch mit einem Gebläse (102) gekoppelt ist;
eine Batterie (106), die an den Elektromotor (104) angeschlossen ist;
eine Alarmvorrichtung (112, 114 oder 116); und
eine elektronische Steuervorrichtung (130), wobei die Steuervorrichtung (130) einen zweiten Wert einer Batterierestzeit auf der Grundlage eines Indizierens von Werten in einer Nachschlagtabelle unter Verwendung eines ersten Werts einer Batterierestzeit und einer Batteriespannung bestimmt, um den zweiten Wert einer Batterierestzeit nachzuschlagen, wobei der erste Wert einer Batterierestzeit eine Abschätzung der Batterierestzeit mindestens teilweise auf der Grundlage eines Werts des Batteriealters, einer abgetasteten Batteriespannung, eines abgetasteten Batteriestroms und einer abgetasteten Batterietemperatur ist, wobei die elektronische Steuervorrichtung (13) die Alarmvorrichtung (112, 114 oder 116) auslöst, wenn der zweite Wert einer Batterierestzeit kleiner ist als ein vordefinierter Schwellenwert, wobei der zweite Wert einer Batterierestzeit ein genauer bestimmter Wert einer Restzeit für das angetriebene Luftreinigungsatemgerät ist als der erste Wert einer Batterierestzeit.

2. Angetriebenes Luftreinigungsatemgerät nach Anspruch 1, wobei die Alarmvorrichtung (112, 114 oder 116) mindestens ein Summeralarm (112) oder ein Vibrationsalarm (114) ist.

3. Angetriebenes Luftreinigungsatemgerät nach Anspruch 1, wobei die Batterie (106) eine Lithium-Ionenbatterie ist.

4. Angetriebenes Luftreinigungsatemgerät nach Anspruch 1, weiterhin umfassend einen integrierten Schaltkreis zur Batterieüberwachung (132), der den ersten Wert einer Batterierestzeit bestimmt, und wobei der integrierte Schaltkreis zur Batterieüberwachung (132) den ersten Wert einer Batterierestzeit und die abgetastete Batteriespannung an die elektronische Steuervorrichtung (130) sendet.

5. Angetriebenes Luftreinigungsatemgerät nach Anspruch 4, wobei der integrierte Schaltkreis zur Batterieüberwachung (132) ferner einen ersten Wert der Restzeit bis zum vollständigen Laden der Batterie auf der Grundlage der Batteriespannung, der Batterietemperatur, des Batteriealters und des Batteriestroms bestimmt; und die elektronische Steuervorrichtung (130) ferner einen zweiten Wert der Restzeit bis zum vollständigen Laden der Batterie durch Indizieren in einer zweiten Nachschlagtabelle unter Verwendung der Batteriespannung und des ersten Werts der Restzeit bis zum vollständigen Laden der Batterie bestimmt.

6. Angetriebenes Luftreinigungsatemgerät nach Anspruch 5, weiterhin umfassend, die elektronische Steuervorrichtung (130) konfiguriert ist, ein Ladegerät (120) von der Batterie (106) zu trennen, wenn der zweite Wert der Restzeit bis zum vollständigen Laden der Batterie angibt, dass die Batterie vollständig geladen ist.

7. Verfahren zum Überwachen einer Batterierestzeit eines angetriebenen Luftreinigungsatemgeräts (PAPR), Folgendes umfassend:
Abtasten einer Batteriespannung einer Batterie (106) des angetriebenen Luftreinigungsatemgeräts;
Abtasten eines Batteriestroms der Batterie (106);
Abtasten einer Batterietemperatur der Batterie (106) ;
Unterhalten eines Werts des Batteriealters der Batterie (106) ;
Bestimmen eines ersten Werts der Batterierestzeit auf der Grundlage der Batteriespannung, der Batterietemperatur, des Werts des Batteriealters und des Batteriestroms;
Bestimmen eines zweiten Werts der Batterierestzeit durch Indizieren in einer ersten Nachschlagtabelle unter Verwendung der Batteriespannung und des ersten Werts der Batterierestzeit, um den zweiten Wert der Batterierestzeit nachzuschlagen, wobei der zweite Wert der Batterierestzeit ein genauer bestimmter Wert der Batterierestzeit für das angetriebene Luftreinigungsatemgerät ist als der erste Wert der Batterierestzeit; und
Auslösen eines Alarms (112, 114 oder 116), wenn der zweite Wert der Batterierestzeit unter einem vordefinierten Schwellenwert liegt.

8. Verfahren nach Anspruch 7, weiterhin Folgendes umfassend:
Bestimmen eines ersten Werts der Restzeit bis zum vollständigen Laden der Batterie auf der Grundlage der Batteriespannung, der Batterietemperatur, des Werts des Batteriealters und des Batteriestroms; und
Bestimmen eines zweiten Werts der Restzeit bis zum vollständigen Laden der Batterie durch Indizieren in einer zweiten Nachschlagtabelle unter Verwendung der Batteriespannung und des ersten Werts der Restzeit bis zum vollständigen Laden der Batterie.

9. Verfahren nach Anspruch 8, weiterhin Folgendes umfassend:
wenn der zweite Wert der Restzeit bis zum vollständigen Laden der Batterie angibt, dass die Batterie (106) vollständig geladen ist, Trennen eines Ladegeräts von der Batterie (106); und Darstellen einer Nachricht auf einer Anzeige des angetriebenen Luftreinigungsatemgeräts, die angibt, dass die Batterie (106) vollständig geladen ist, wenn der zweite Wert der Restzeit bis zum vollständigen Laden der Batterie angibt, dass die Batterie (106) vollständig geladen ist.

10. Verfahren nach Anspruch 7, wenn der zweite Wert der Batterierestzeit unter einem zweiten vordefinierten Schwellenwert liegt, Trennen der Batterie (106) von einem Elektromotor (104) des angetriebenen Luftreinigungsatemgeräts, wobei der zweite vordefinierte Schwellenwert einen geringeren Wert aufweist als der erste vordefinierte Schwellenwert.

11. Verfahren nach Anspruch 7, weiterhin umfassend Darstellen des zweiten Werts der Batterierestzeit auf einer Anzeige des angetriebenen Luftreinigungsatemgeräts.

## Revendications

1. Appareil respiratoire motorisé à épuration d'air (PAPR), comprenant :
un moteur électrique (104) mécaniquement accouplé à une soufflante (102) ;
une batterie (106) couplée au moteur électrique (104) ;
un dispositif d'alarme (112, 114, ou 116) ; et
une unité de commande électronique (130), dans lequel l'unité de commande (130) détermine une seconde valeur restante de temps de batterie sur la base d'un indexage dans une table à consulter de valeurs en utilisant une première valeur restante de temps de batterie et une tension de batterie pour rechercher la seconde valeur restante de temps de batterie, dans lequel la première valeur restante de temps de batterie est une estimation du temps restant de batterie sur la base au moins en partie d'une valeur de âge de batterie, d'une tension de batterie détectée, d'un courant de batterie détecté, et d'une température de batterie détectée, dans lequel l'unité de commande électronique (13) actionne le dispositif d'alarme (112, 114, ou 116) lorsque la seconde valeur restante de temps de batterie est inférieure à un seuil prédéfini, dans lequel la seconde valeur restante de temps de batterie est une valeur restante de temps déterminée plus précisément, pour l'appareil respiratoire motorisé à épuration d'air, que la première valeur restante de temps de batterie.

2. Appareil respiratoire motorisé à épuration d'air selon la revendication 1, dans lequel le dispositif d'alarme (112, 114, ou 116) est au moins l'une d'une alarme sonore (112) ou d'une alarme à vibrations (114).

3. Appareil respiratoire motorisé à épuration d'air selon la revendication 1, dans lequel la batterie (106) est une batterie au lithium-ion.

4. Appareil respiratoire motorisé à épuration d'air selon la revendication 1, comprenant en outre un circuit intégré de surveillance de batterie (132) qui détermine la première valeur restante de temps de batterie, et dans lequel le circuit intégré de surveillance de batterie (132) transmet la première valeur restante de temps de batterie et la tension de batterie détectée à l'unité de commande électronique (130).

5. Appareil respiratoire motorisé à épuration d'air selon la revendication 4, dans lequel le circuit intégré de surveillance de batterie (132) détermine en outre une première valeur de temps restant jusqu'à ce que la batterie soit complètement chargée sur la base de la tension de batterie, de la température de batterie, de l'âge de batterie, et du courant de batterie ; et l'unité de commande électronique (130) détermine en outre une seconde valeur de temps restant jusqu'à ce que la batterie soit complètement chargée par indexage dans une seconde table à consulter en utilisant la tension de batterie et la première valeur de temps restant jusqu'à ce que la batterie soit complètement chargée.

6. Appareil respiratoire motorisé à épuration d'air selon la revendication 5, comprenant en outre, lorsque la seconde valeur de temps restant jusqu'à ce que la batterie soit complètement chargée indique que la batterie est complètement chargée, l'unité de commande électronique (130) est configurée pour déconnecter un chargeur (120) à partir de la batterie (106).

7. Procédé de surveillance d'un temps de batterie restant d'appareil respiratoire motorisé à épuration d'air (PAPR), comprenant :
la détection d'une tension de batterie d'une batterie (106) de l'appareil respiratoire motorisé à épuration d'air ;
la détection d'un courant de batterie de la batterie (106) ;
la détection d'une température de batterie de la batterie (106) ;
le maintien d'une valeur d'âge de batterie de la batterie (106) ;
la détermination d'une première valeur de temps de batterie restant sur la base de la tension de batterie, de la température de batterie, de la valeur d'âge de batterie, et du courant de batterie ;
la détermination d'une seconde valeur de temps de batterie restant par indexage dans une première table à consulter en utilisant la tension de batterie et la première valeur de temps de batterie restant pour rechercher la seconde valeur du temps de batterie restant, dans lequel la seconde valeur du temps de batterie restant est une valeur déterminée plus précisément, du temps de batterie restant pour l'appareil respiratoire motorisé à épuration d'air, que la première valeur du temps de batterie restant ; et
lorsque la seconde valeur de temps de batterie restant est inférieure à un seuil prédéfini, l'actionnement d'une alarme (112, 114, ou 116).

8. Procédé selon la revendication 7, comprenant en outre :
la détermination d'une première valeur de temps restant jusqu'à ce que la batterie soit complètement chargée sur la base de la tension de batterie, de la température de batterie, de la valeur d'âge de batterie, et du courant de batterie ; et
la détermination d'une seconde valeur de temps restant jusqu'à ce que la batterie soit complètement chargée par indexage dans une seconde table à consulter en utilisant la tension de batterie et la première valeur de temps restant jusqu'à ce que la batterie soit complètement chargée.

9. Procédé selon la revendication 8, comprenant en outre :
lorsque la seconde valeur de temps restant jusqu'à ce que la batterie soit complètement chargée indique que la batterie (106) est complètement chargée, la déconnexion d'un chargeur à partir de la batterie (106) ; et la présentation d'un message sur une unité d'affichage de l'appareil respiratoire motorisé à épuration d'air indiquant que la batterie (106) est complètement chargée lorsque la seconde valeur de temps restant jusqu'à ce que la batterie soit complètement chargée indique que la batterie (106) est complètement chargée.

10. Procédé selon la revendication 7, lorsque la seconde valeur de temps de batterie restant est inférieure à un second seuil prédéfini, le découplage de la batterie (106) à partir d'un moteur électrique (104) de l'appareil respiratoire motorisé à épuration d'air, dans lequel le second seuil prédéfini possède une valeur inférieure à la valeur de premier seuil prédéfini.

11. Procédé selon la revendication 7, comprenant en outre la présentation de la seconde valeur de temps de batterie restant sur une unité d'affichage de l'appareil respiratoire motorisé à épuration d'air.
